# EUROPEAN PATENT APPLICATION

(11) **EP 2 546 885 A1**
(43) Date of publication of application: **16.01.2013**
(21) Application number: 10847480.0
(22) Date of filing: 10.09.2010
(51) Int. Cl.: H01L 31/04, H02J 3/38

(54) **PHOTOVOLTAIC POWER GENERATION SYSTEM**

(30) Priority: 10.03.2010 JP 2010053067
(71) Applicant: Kabushiki Kaisha Toshiba, Minato-ku Tokyo 105-8001 (JP)
(72) Inventor: KASAI, Chihiro, Tokyo 105-8001 (JP); TONOGAITO, Kazuhiko, Tokyo 105-8001 (JP)
(74) Representative: HOFFMANN EITLE
(86) International application number: PCT/JP2010/065589
(87) International publication number: WO 2011/111252

(57) **Abstract**

The embodiments comprise a solar cell array formed by arranging plural solar cell strings each having solar cell modules connected in series; a solar-cell-related information holding unit for holding solar-cell-related information on any of solar cell modules, solar cell strings, and solar cell array; and an information transmitting unit for transmitting the solar-cell-related information acquired from solar-cell-related information holding unit to an outside. The solar-cell-related information holding unit includes an identification information holding part for holding identification information for identifying any of solar cell modules, solar cell strings, and solar cell array; a solar cell information holding part for holding information on any of solar cell modules, solar cell strings, and solar cellarray; and a position information holding part for holding position information for identifying a position of any of solar cell modules, solar cell strings, and solar cell array.

## Description

### TECHNICAL FIELD

Embodiments of the present invention relate to a photovoltaic power generation system configured to generate power using solar light.

### BACKGROUND ART

In a photovoltaic power generation system, DC power generated by light irradiation onto solar cell modules is converted into AC power by an inverter, and the AC power is then supplied to a power system. The photovoltaic power generation system includes solar cell modules, a junction box, an inverter, a step-up transformer, an AC breaker, an interconnection transformer, and an interconnection breaker.

The solar cell modules generate DC power by being irradiated with light. A solar cell string is formed by connecting multiple solar cell modules in series. The solar cell string accumulates DC power generated by each of the solar cell modules, and outputs the accumulated power between a positive-electrode terminal and a negative-electrode terminal. The photovoltaic power generation system includes multiple solar cell strings, and the positive-electrode terminal and the negative-electrode terminal of each solar cell string are connected to the junction box.

The junction box collects the DC power sent from each of the multiple solar cell strings, and sends the accumulated DC power to the inverter. The inverter then converts the DC power sent from the junction box into AC power and sends the AC power to the step-up transformer. The step-up transformer converts the AC power sent from the inverter into AC power having a predetermined voltage, and sends the AC power thus obtained to the interconnection transformer via the AC breaker. The interconnection transformer converts the AC power thus received into a voltage appropriate for interconnection with the system power, and sends the power to the system power through the interconnection breaker. Note that the stronger the light applied onto the solar cell modules is, the larger the output current from the solar cell modules 1 is, and therefore the larger the power provided by the solar power generation system is.

### PRIOR ART DOCUMENTS

### PATENT DOCUMENTS

Patent Document 1: Japanese Patent Application Publication No. 2001-24204
Patent Document 2: Japanese Patent Application Publication No. Hei. 8-64653

### SUMMARY OF THE INVENTION

### PROBLEMS TO BE SOLVED BY THE INVENTION

Since the above-described conventional photovoltaic power generation system is installed outdoors, unexpected troubles occur in the solar cell modules used in the photovoltaic power generation system, such as defacement on the surface glass due to bird feces or breakage of the surface glass due to hailstones. As a result, there arise problems such as hot spot in part of the solar cell modules.

If such solar cell module having a failure is left neglected, an expected power amount cannot be obtained, resulting in a problem of the late return on investment. A security problem also occurs, such as burning of the back surface of the solar cell modules by the hot spot. Accordingly, the solar power generation system needs to detect a failure in a solar cell module and specify the solar cell module having the failure.

However, since a number of the solar cell modules are installed, problems such as the following one occurs. Specifically, even when a failure has been found, the specification of the place requires tracing of the wiring, i.e., takes time and effort. Further, a conventional photovoltaic power generation system is used for the power generation purpose only; therefore, an enormous area occupied by the installation of the photovoltaic power generation system is used only for a single purpose.

An objective of the present invention is to provide a versatile photovoltaic power generation system which enables specifying a place of a failure in the solar cell modules easily when the failure has been found.

### MEANS FOR SOLVING THE PROBLEMS

In order to solve the above problems, a photovoltaic power generation system of the embodiments comprises: a solar cell array formed by arranging a plurality of solar cell strings each having solar cell modules connected in series; a solar-cell-related information holding unit configured to hold solar-cell-related information on any of the solar cell modules, the solar cell strings, and the solar cell array; and an information transmitting unit configured to transmit the solar-cell-related information acquired from the solar-cell-related information holding unit to an outside. The solar-cell-related information holding unit includes: an identification information holding part configured to hold identification information for identifying any of the solar cell modules, the solar cell strings, and the solar cell array; a solar cell information holding part configured to hold information on any of the solar cell modules, the solar cell strings, and the solar cell array; and a position information holding part configured to hold position information for identifying a position of any of the solar cell modules, the solar cell strings, and the solar cell array.

### BRIEF DESCRIPTION OF THE DRAWINGS

[Fig. 1] Fig. 1 is a diagram showing the configuration of a main part of a photovoltaic power generation system according to a first embodiment.
[Fig. 2] Fig. 2 is a diagram showing the configuration of solar-cell-related information according to the first embodiment.
[Fig. 3] Fig. 3 is a diagram showing an example of how position information is configured, according to the first embodiment.
[Fig. 4] Fig. 4 is a diagram showing an example of how position information is configured, according to the first embodiment.
[Fig. 5] Fig. 5 is a diagram showing an example of how position information is configured, according to the first embodiment.
[Fig. 6] Fig. 6 is a diagram showing an example of howposition information is configured, according to the first embodiment.
[Fig. 7] Fig. 7 is a diagram showing the configuration of a main part of a photovoltaic power generation system according to a second embodiment.
[Fig. 8] Fig. 8 is a flowchart showing the operations of the photovoltaic power generation system according to the second embodiment.
[Fig. 9] Fig. 9 is a diagram showing the configuration of a main part of a photovoltaic power generation system according to a third embodiment.
[Fig. 10] Fig. 10 is a flowchart showing the operations of the photovoltaic power generation system according to the third embodiment.
[Fig. 11] Fig. 11 is a diagram showing the configuration of amain part of a photovoltaic power generation system according to a fourth embodiment.
[Fig. 12] Fig. 12 is a diagram showing the configuration of a main part of the photovoltaic power generation system according to the fourth embodiment.

### MODES FOR CARRYING OUT THE INVENTION

Embodiments will be described in detail below with reference to the drawings.

### (First Embodiment)

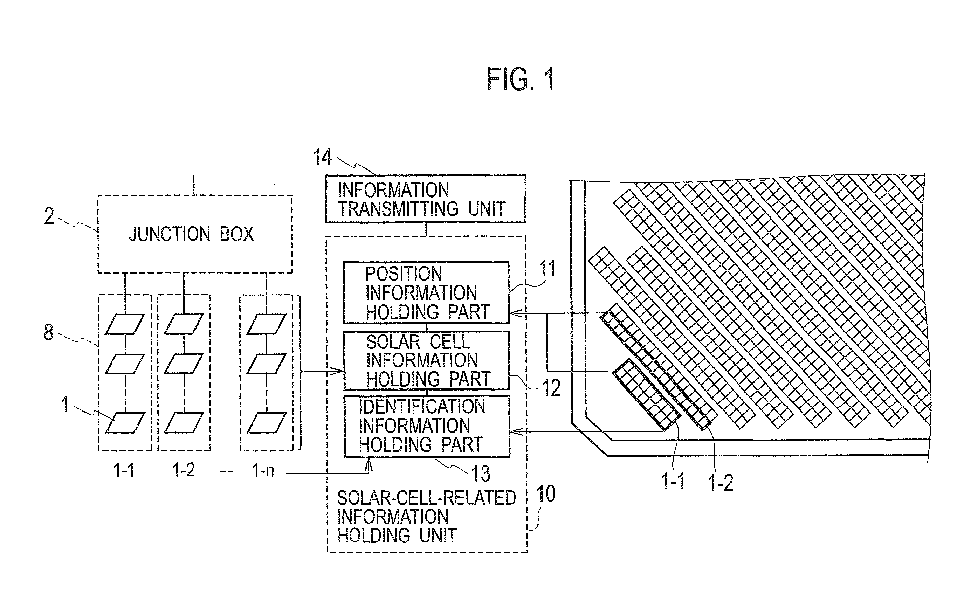

Fig. 1 is a diagram showing the configuration of a main part of a photovoltaic power generation system according to a first embodiment. Note that Fig. 1 shows multiple solar cell strings and a junction box only.

This photovoltaic power generation system consists of a photovoltaic power generation system unit, a solar-cell-related information holding unit 10, and an information transmitting unit 14.

The photovoltaic power generation system unit includes: solar cell arrays 1-1 to 1-n in which multiple solar cell strings 8 are arranged; and a junction box 2. Each solar cell string 8 is formed of one or more solar cell modules 1 connected in series. The solar-cell-related information holding unit 10 includes: an identification information holding part 13 configured to hold identification information for identifying the solar cell modules 1, the solar cell strings 8, or the solar cell arrays 1-1 to 1-n; a solar cell information holding part 12 configured to hold information on the solar cell modules 1, the solar cell strings 8, or the solar cell arrays 1-1 to 1-n; and a position information holding part 11 configured to hold position information 16 on the solar cell modules 1, the solar cell strings 8, or the solar cell arrays 1-1 to 1-n.

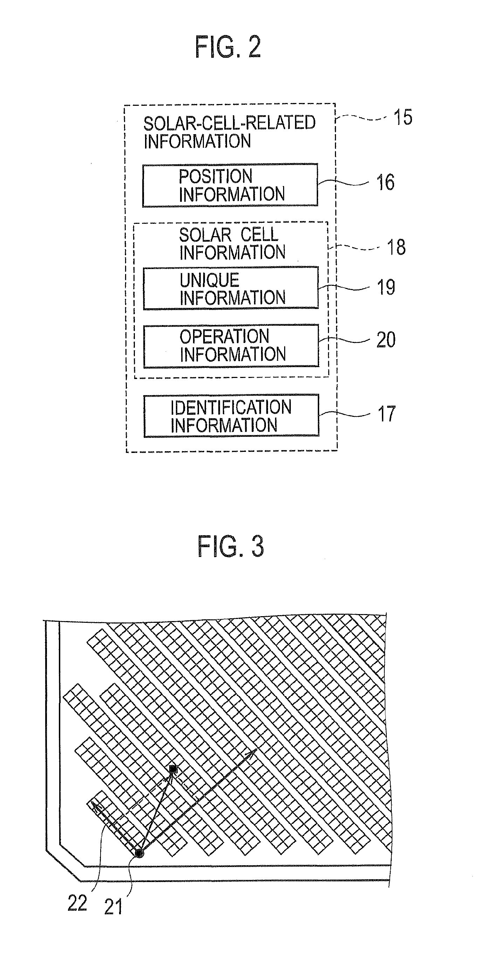

The solar-cell-related information holding unit 10 hold solar-cell-related information 15 on each of the solar cell modules 1, each of the solar cell strings 8, or each of the solar cell arrays 1-1 to 1-n. As shown in Fig. 2, the solar-cell-related information 15 indicates: identification information 17 on the solar cell modules 1, the solar cell strings 8, or the solar cell arrays 1-1 to 1-n; solar cell information 18 on the solar cell modules 1, the solar cell strings 8, or the solar cell arrays 1-1 to 1-n; and the position information 16 on the solar cell modules 1, the solar cell strings 8, or the solar cell arrays 1-1 to 1-n.

The identification information 17 indicates information uniquely identifying the solar cell modules 1, the solar cell strings 8, or the solar cell arrays 1-1 to 1-n. The identification information can be one or more information items such as an optionally-assigned symbol, a serial number of the solar cell module 1, and the position information 16.

The position information 16 can be obtained as shown in Fig. 3. Specifically, first, a reference point 21 and two reference direction vectors 22 which do not align each other are defined. Then, a position vector from the reference point 21 to the corresponding solar cell module 1, the corresponding solar cell string 8, or a corresponding one of the solar cell arrays 1-1 to 1-n is decomposed into the reference direction vectors 22. The coefficients of the vectors obtained by the decomposition are the position information 16.

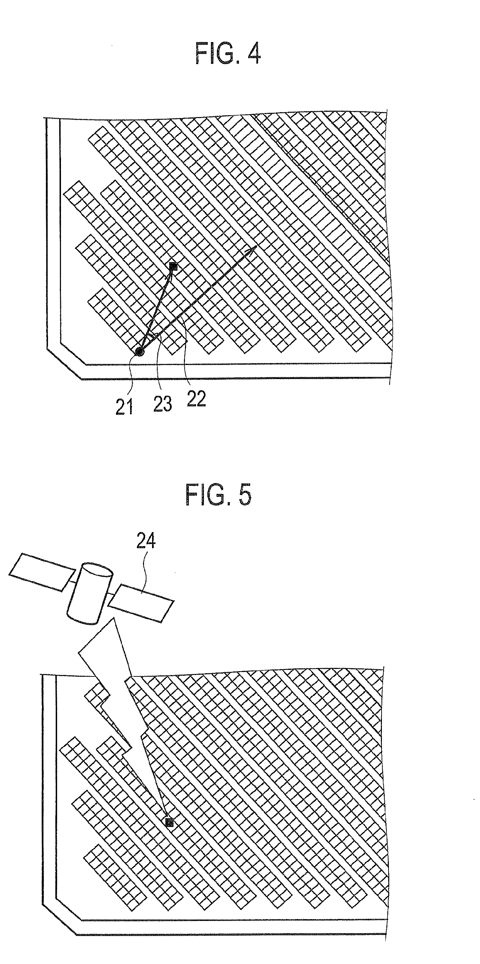

Alternatively, the position information 16 can also be obtained as shown in Fig. 4. Specifically, first, the reference point 21, one reference direction vector 22, and a reference rotational direction 23 are defined. Then, the angle formed in the reference rotation direction 23 between the reference direction vector 22 and a position vector from the reference point 21 to the corresponding solar cell module 1, the corresponding solar cell string 8, or a corresponding one of the solar cell arrays 1-1 to 1-n is obtained, as well as the length of the position vector. These angle and length can be used as the position information 16.

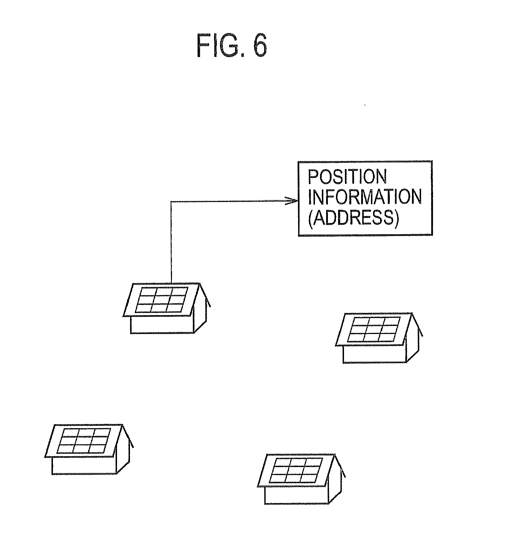

As shown in Fig. 5, the position information 16 can also be the longitude and latitude of the position of the corresponding solar cell module 1, the corresponding solar cell string 8, or a corresponding one of the solar cell arrays 1-1 to 1-n, which are measured using longitude/latitude measurement means 24. As shown in Fig. 6, the position information 16 can be the address of the corresponding solar cell module 1, the corresponding solar cell string 8, or a corresponding one of the solar cell arrays 1-1 to 1-n.

As Fig. 2 shows, the solar cell information 18 consists of one or a combination of unique information 19 and operation information 20 of the corresponding solar cell module 1, and changes according to the purpose. The unique information 19 is information on any of the solar cell modules 1, the solar cell strings 8, and the solar cell arrays 1-1 to 1-n, the information being determined in manufacturing or introduction thereof, and not time-dependently changing in operation. For example, the unique information 19 consists of one or a combination of information items such as a serial number, a model name, a manufacturer's name, a factory test value, an introduction date, the number of serial arrangements, the number of parallel arrangements, and an installation angle or an orientation angle in a fixed mount or the like.

The operation information 20 is information on any of the solar cell modules 1, the solar cell strings 8, and the solar cell arrays 1-1 to 1-n, the information time-dependently changing in operation. The operation information 20 consists of one or a combination of information items such as current information, voltage information, power information, power amount information, temperature information, insolation intensity information, and an installation angle or an orientation angle in a tracking mount or the like.

The solar-cell-related information holding unit 10 is connected to the information transmitting unit 14, and outputs the solar-cell-related information to the information transmitting unit 14. The information transmitting unit 14 sends the solar-cell-related information 15 to the outside in a wired or wireless manner.

Next, a description is given of the operations of the solar power generation system according to the first embodiment configured as above.

When a certain solar cell string 8 includes a solar cell module 1 having decreased output, current outputted from that solar cell module 1, or the solar cell string 8 including that solar cell module 1, or the solar cell array including that solar cell module 1 becomes smaller than current outputted from the other solar cell strings 8.

Then, if the operation information 20 of the solar cell information 18 in the solar cell information holding part 12 includes the current information or the power information, the value in the current information or the power information decreases upon the output decrease. As the solar-cell-related information 15, the solar-cell-related information holding unit 10 sends the information transmitting unit 14 the solar cell information consisting of the unique information and the operation information including the current information or the power information, the position information, and the identification information. The information transmitting unit 14 then sends the solar-cell-related information 15 acquired from the solar-cell-related information holding unit 10 to the outside.

When the solar-cell-related information 15 is externally received, the position of the solar cell module 1 having decreased output, or the solar cell string 8 including that solar cell module 1, or a certain one of the solar cell array 1-1 to 1-n including that solar cell module 1 can be immediately identified based on the operation information including the current information or the power information, the identification information, and the position information. Thereby, even if the output decrease is due to breakdown or deterioration of the solar cell module 1 and requires replacement, the replacement can be done immediately without tracing the wires.

As described above, with the photovoltaic power generation system according to the first embodiment, upon detection of output decrease in the solar cell module 1, the position (place) thereof can be specified, and therefore replacement can be done reliably and easily. In addition, the remote monitoring thus enabled allows easy maintenance, low operation costs, and provision of a solar power generation system which is safe and requires low maintenance costs.

### (Second Embodiment)

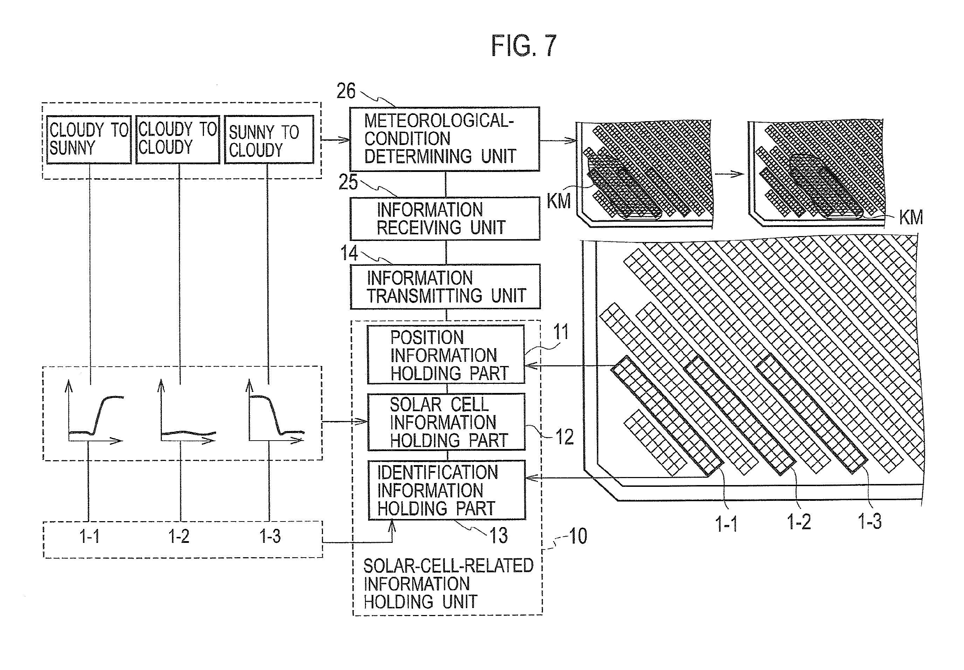

Fig. 7 is a diagram showing the configuration of a main part of a photovoltaic power generation system according to a second embodiment. The photovoltaic power generation system according to the second embodiment shown in Fig. 7 is characterized in that an information receiving unit 25 and a meteorological-condition determining unit 26 are added to the configuration of the photovoltaic power generation system according to the first embodiment shown in Fig. 1. Parts in Fig. 7 having similar configurations to those in Fig. 1 are not described again.

The information receiving unit 25 receives the solar-cell-related information 15 transmitted by the information transmitting unit 14, and sends the meteorological-condition determining unit 26 the solar-cell-related information 15 thus received. The operation information 20 of the solar cell information 18 of the solar-cell-related information 15 includes information used for meteorological-condition determination by the meteorological-condition determining unit 26, the information including one or more information items such as, for example, the current, temperature, and insolation intensity of any of the solar cell modules 1, the solar cell strings 8, and the solar cell arrays 1-1 to 1-n.

The meteorological-condition determining unit 26 determines the meteorological conditions based on the information used for the meteorological-condition determination included in the operation information 20 of the solar-cell-related information 15 received from the information receiving unit 25.

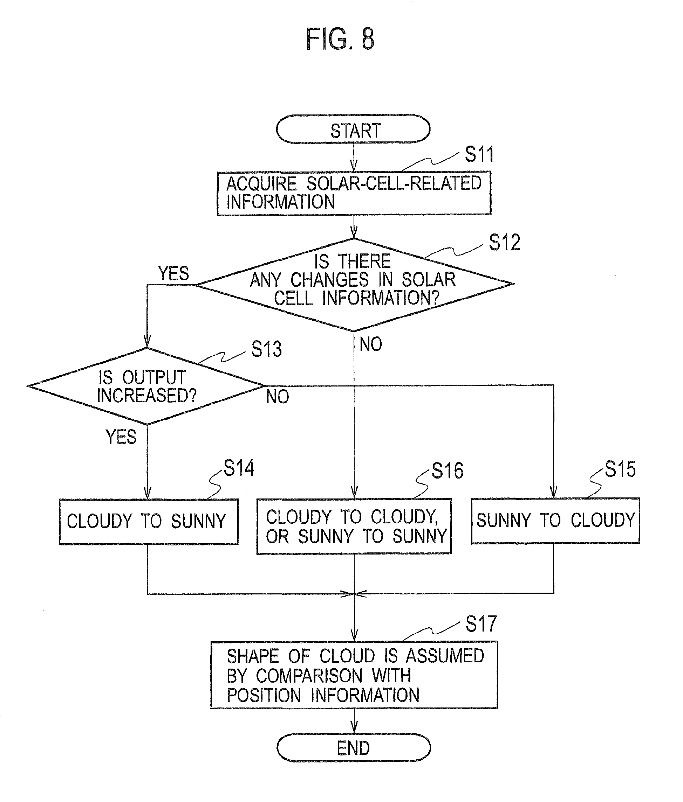

Next, with reference to a flowchart shown in Fig. 8, a description is given of the operations of the solar power generation system according to the second embodiment configured as above.

First, the meteorological-condition determining unit 26 acquires the solar-cell-related information 15 from the information receiving unit 25 (Step S11). Next, the meteorological-condition determining unit 26 determines whether, for example, a value in the meteorological-condition determination information used for the meteorological-condition determination has changed or not, using the information used for the meteorological-condition determination included in the solar-cell-related information 15 (Step S12).

When the value in the meteorological-condition determination information has increased to be equal to or more than a threshold, for example (YES in Step S13), the meteorological-condition determiningunit26determinesthat the weather has changed from cloudy to sunny (Step S14). When the value in the meteorological-condition determination information has decreased to fall below the threshold, for example (NO in Step S13), the meteorological-condition determining unit 26 determines that the weather has changed from sunny to cloudy (Step S15). When the value in the meteorological-condition determining information is unchanged, the meteorological-condition determining unit 26 determines cloudy to cloudy or sunny to sunny (Step S16). This meteorological-condition determination processing is performed for every solar-cell-related information 15.

The shape of a cloud is assumed by comparing the meteorological-condition determination result with the position information obtained through Steps S14 to S16 (Step S17). To be more specific, if the meteorological-condition determination is carried out depending not on the weather such as cloudy or sunny, but on the presence of clouds for example, cloud distribution for the position in the solar photovoltaic generation system the information on which is held in the solar-cell-related information holding unit 10 can be obtained without additional equipment.

Further, since the position information 16 is included in the solar-cell-related information 15, the meteorological conditions can be determined for each position indicated by the position information 16. Furthermore, by graphically illustrating the meteorological-condition determination result for each position, the meteorological-condition information on a position in the solar power generation system the information on which is held in the solar-cell-related information holding unit 10 can be obtained without additional equipment.

As described above, with the photovoltaic power generation system according to the second embodiment, a photovoltaic power generation system can be provided in which the meteorological-condition information on a position in the photovoltaic power generation system the information on which is held in the solar-cell-related information holding unit 10 can be obtained without additional equipment.

### (Third Embodiment)

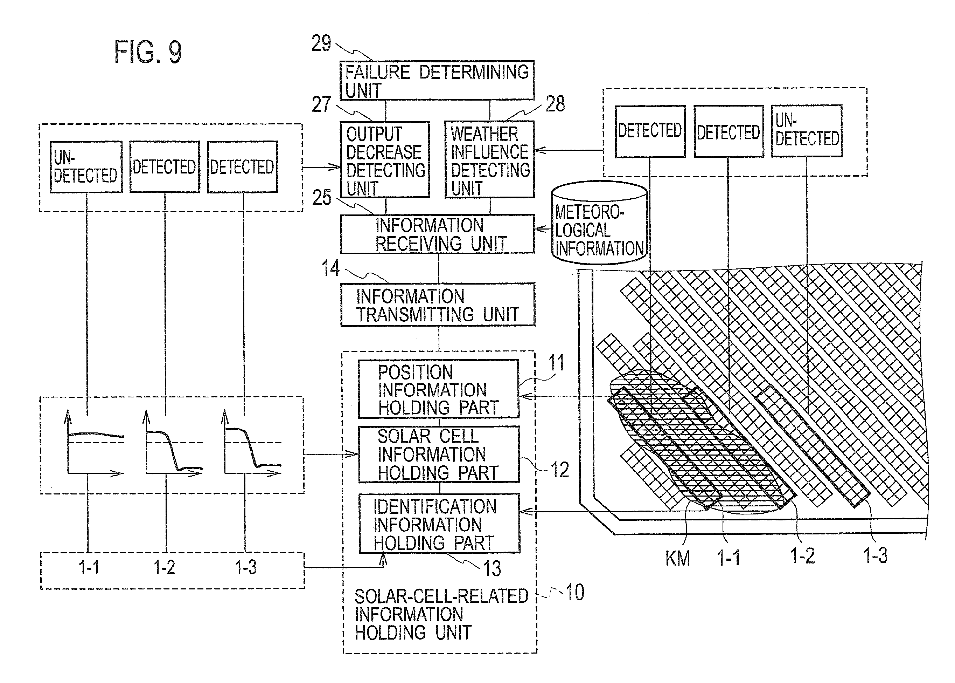

Fig. 9 is a diagram showing the configuration of a main part of a photovoltaic power generation system according to a third embodiment. The photovoltaic power generation system according to the third embodiment shown in Fig. 9 is characterized in that the information receiving unit 25, an output decrease detecting unit 27, a weather influence detecting unit 28, and a failure determining unit 29 are further added to the configuration of the photovoltaic power generation system according to the first embodiment. Parts in Fig. 9 having similar configurations to those in Fig. 1 are not described again.

The information receiving unit 25 receives the solar-cell-related information 15 transmitted by the information transmitting unit 14 and meteorological information from a database, and sends the received solar-cell-related information 15 to the output decrease detecting unit 27 and to the weather influence detecting unit 28, and also sends the meteorological information to the weather influence detecting unit 28.

The operation information 20 of the solar cell information 18 of the solar-cell-related information 15 is information used by the output decrease detecting unit 27 for detecting an output decrease in the solar cell modules 1, the solar cell strings 8, or the solar cell arrays 1-1 to 1-n. Such information includes one or more information items such as, for example, current, voltage, and power from the solar cell modules 1, the solar cell strings 8, or the solar cell arrays 1-1 to 1-n.

The meteorological information is information used by the weather influence detecting unit 28 for detecting weather influence, and includes one or more information items such as, for example, cloud arrangements, a photograph of clouds, an insolation intensity at each position, the position of the sun, information on an object which might make a shadow, and information obtained by the method of Example 2.

The output decrease detecting unit 27 sends the failure determining unit 29 the detection information on output decrease in any of the solar cell modules 1, the solar cell strings 8, or the solar cell arrays 1-1 to 1-n, along with the solar-cell-related information 15 thereof in some cases. The weather influence detecting unit 28 sends the failure determining unit 29 the detection information on the weather influence and the meteorological-condition information, along with the solar-cell-related information 15 thereof in some cases.

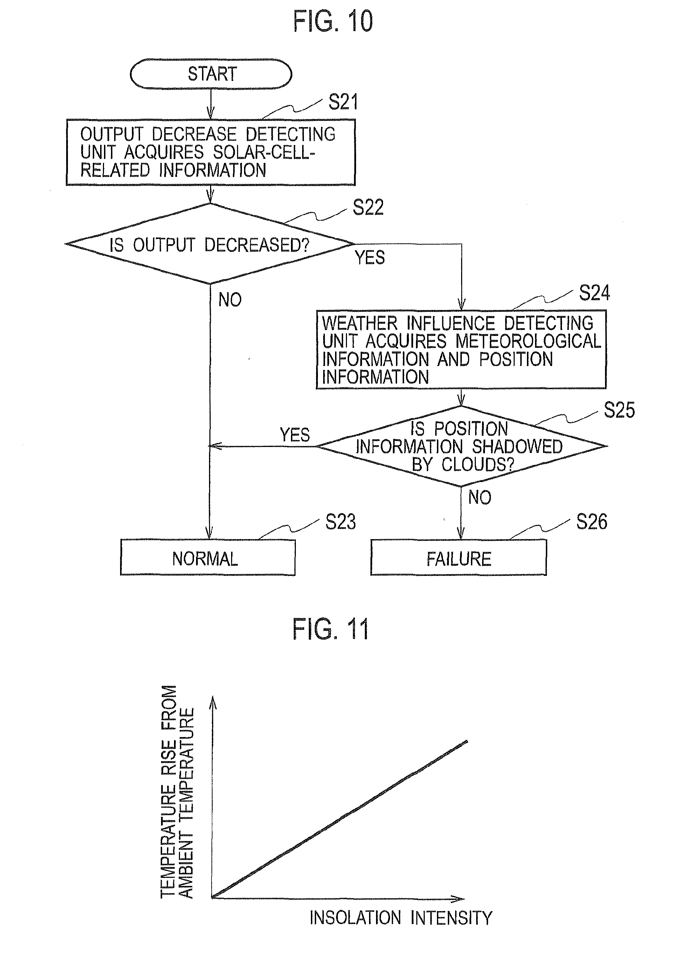

Next, with reference to a flowchart in Fig. 10, a description is given of the operations of the photovoltaic power generation system according to the third embodiment configured as above.

First, the output decrease detecting unit 27 acquires the solar-cell-related information 15 from the information receiving unit 25 (Step S21). Next, using the information used for output decrease detection which is included in the solar-cell-related information 15, the output decrease detecting unit 27 determines whether a value in the information used for output decrease has fallen to or below a predetermined threshold, for example (Step S22). This output decrease determination processing is carried out for every solar-cell-related information 15. When the value in the information used for output decrease is not equal to or below the predetermined threshold, the failure determining unit 29 determines that the output decrease is normal (Step S23).

Next, when the value in the information used for output decrease has fallen to or below the predetermined threshold in Step S22, the weather influence detecting unit 28 acquires the position information 16 included in the solar-cell-related information 15 as well as the meteorological information (Step S24), and using the position information 16 andthemeteorological-condition information, determines whether the position indicated by the position information 16 is shadowed by clouds or not, for example (Step S25). This determination processing is performed for every solar-cell-related information 15.

Next, when the position indicated by the position information 16 is shadowed by clouds, the failure determining unit 29 determines that the output decrease is normal. When the position indicated by the position information 16 is not shadowed by clouds, i.e., when the detected output decrease has been detected as not being influenced by the weather, the failure determining unit 29 determines that the output decrease is due to a failure (Step S26). This failure includes, for example, physical failures such as defacement or breakage of the surface of the solar cell modules, breakage or deterioration of the solar cell modules 1, electrical failures such as circuit disconnection, and the like, and excludes influences by the weather.

With the above configuration, the physical failure or electrical failure of the solar cell modules 1, the solar cell strings 8, or the solar cell arrays 1-1 to 1-n is detected by excluding the elements of meteorological conditions. Thereby, the failure can be detected with high accuracy. Moreover, not requiring additional equipment allows reduction in introduction costs. The system is thus provided with a self-failure-detection function.

If a failure is detected even when there is no failure, it is conceivable that snow is covering the position indicated by the solar-cell-related information 15. By graphically illustrating snow accumulation at each position, snow accumulation information at each position in the photovoltaic power generation system the information on which is held in the solar-cell-related information holding unit 10 can be obtained without additional equipment.

As described above, the photovoltaic power generation system according to the third embodiment can obtain snow accumulation information on a position in the photovoltaic power generation system the information on which is held in the solar-cell-related information holding unit 10. Accordingly, a photovoltaic power generation system can be provided which is capable of accurately detecting the physical failure or electrical failure of the solar cell modules 1, the solar cell strings 8, or the solar cell arrays 1-1 to 1-n, which allows reduction in the introduction costs, and which is provided with a self-failure-detection function.

### (Fourth Embodiment)

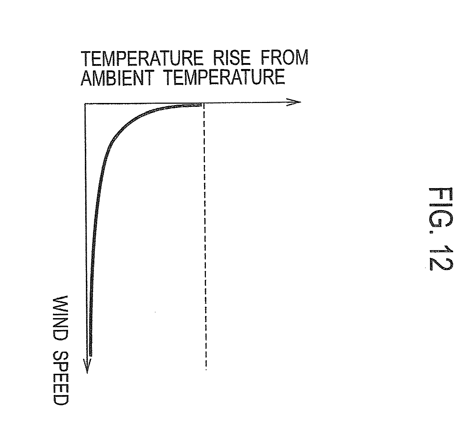

Figs. 11 and 12 are diagrams showing the configuration of a main part of a photovoltaic power generation system according to a fourth embodiment.

The operation information 20 of the solar cell information 18 of the solar-cell-related information 15 is information with which the output of any of the solar cell modules 1, the solar cell strings 8, and the solar cell arrays 1-1 to 1-n can be determined, and includes, for example, current or voltage, the temperature of any of the solar cell modules 1, the solar cell strings 8, and the solar cell arrays 1-1 to 1-n, and the ambient temperature of any of the solar cell modules 1, the solar cell strings 8, and the solar cell arrays 1-1 to 1-n.

As Fig. 11 shows, a temperature rise from the ambient temperature of any of the solar cell modules 1, the solar cell strings 8, and the solar cell arrays 1-1 to 1-n is proportional to the insolation intensity. In addition, as shown in Fig. 12, a temperature rise from the ambient temperature of any of the solar cell modules 1, the solar cell strings 8, and the solar cell arrays 1-1 to 1-n is inversely proportional to the wind speed exponentially.

For these reasons, the insolation intensity can be estimated for each solar-cell-related information 15 by including an insolation intensity in the operation information 20 of the solar cell information 18 of the solar-cell-related information 15, or by the method of the photovoltaic power generation system according to the second embodiment. Based on the insolation intensity thus estimated, the wind speed at a position indicated by the position information 16 of the solar-cell-related information 15 can be calculated by a wind-speed calculator (not shown) without additional equipment.

Solar cell modules being at a windy position indicated by the position information 16 of the solar-cell-related information 15 can be dealt with by measures such as being laid down or being taken off. Thereby, a safe and secure solar power generation system can be provided.

Further, by graphically illustrating the wind speed for each position, wind-speed information on a position in the photovoltaic power generation system the information on which is held in the solar-cell-related information holding unit 10 can be obtained without additional equipment.

As described above, with the photovoltaic power generation system according to the fourth embodiment, a safe and versatile photovoltaic power generation system can be provided, which can obtain the wind speed at a position in the photovoltaic power generation system the information on which is held in the solar-cell-related information holding unit 10, and which allows taking measures when the wind speed is high.

Several embodiments of the preset invention have been described, but these embodiments are presented as examples, and are not intended to limit the scope of the invention. These new embodiments can be implemented in other various modes, and can be variously omitted, replaced, or changed without departing from the gist of the invention. These embodiments and their modifications are included in the scope or the gist of the invention, and are included in the inventions described in Claims and in the scope of their equivalents.

## Claims

1. A photovoltaic power generation system comprising:
a solar cell array formed by arranging a plurality of solar cell strings each having solar cell modules connected in series;
a solar-cell-related information holding unit configured to hold solar-cell-related information on any of the solar cell modules, the solar cell strings, and the solar cell array; and
an information transmitting unit configured to transmit the solar-cell-related information acquired from the solar-cell-related information holding unit to an outside,
wherein
the solar-cell-related information holding unit includes:
an identification information holding part configured to hold identification information for identifying any of the solar cell modules, the solar cell strings, and the solar cell array;
a solar cell information holding part configured to hold information on any of the solar cell modules, the solar cell strings, and the solar cell array; and
a position information holding part configured to hold position information for identifying a position of any of the solar cell modules, the solar cell strings, and the solar cell array.

2. The photovoltaic power generation system according to claim 1, comprising:
an information receiving unit configured to receive the solar-cell-related information from the information transmitting unit; and
a meteorological-condition determining unit configured to determine a meteorological condition based on the solar-cell-related information received by the information receiving unit.

3. The photovoltaic power generation system according to claim 1, comprising:
an output decrease detecting unit configured to detect output decrease in any of the solar cell modules, the solar cell strings, and the solar cell array, based on the solar-cell-related information from the information transmitting unit;
a weather influence detecting unit configured to detect an influence by weather on any of the solar cell modules, the solar cell strings, and the solar cell array, based on the solar-cell-related information from the information transmitting unit and on meteorological information; and
a failure detecting unit configured to determine a failure of any of the solar cell modules, the solar cell strings, and the solar cell array, based on information from the output decrease detecting unit and information from the weather influence detecting unit.

4. The photovoltaic power generation system according to claim 1, wherein
the solar-cell-related information includes temperature information and ambient temperature information on any of the solar cell modules, the solar cell strings, and the solar cell array.

5. The photovoltaic power generation system according to claim 1, comprising a wind-speed calculating unit configured to calculate a wind speed at a position of any of the solar cell modules, the solar cell strings, and the solar cell array, based on an insolation intensity at the position.
